# EUROPEAN PATENT APPLICATION

(11) **EP 2 546 385 A1**
(43) Date of publication of application: **16.01.2013**
(21) Application number: 11753370.3
(22) Date of filing: 08.03.2011
(51) Int. Cl.: C23C 14/34

(54) **SPUTTERING DEVICE**

(30) Priority: 09.03.2010 JP 2010051566
(71) Applicant: EMD Corporation, Shiga 520-2323 (JP)
(72) Inventor: EBE, Akinori, Yasu-shi Shiga 520-2323 (JP); WATANABE, Masanori, Katano-shi Osaka 576-0021 (JP)
(74) Representative: Ludewigt, Christoph
(86) International application number: PCT/JP2011/055407
(87) International publication number: WO 2011/111712

(57) **Abstract**

The present invention aims at providing a sputtering system capable of efficiently generating high-density plasma near the surface of a sputter target and forming a film at a high rate. It also aims at providing a large-area sputtering system and a plasma processing system having a simple structure and allowing the sputter target to be easily attached/detached, maintained, or operated otherwise. The present invention provides a sputtering system in which an inductively-coupled antenna conductor plate is attached to a portion of a vacuum chamber, wherein: a sputter target plate is attached to the inductively-coupled antenna conductor on its plasma formation space side; one end of the antenna conductor is connected to a radio-frequency power source; and the other end is grounded through a capacitor. A plurality of antenna conductors may be provided to form a large-area sputtering system.

## Description

### TECHNICAL FIELD

The present invention relates to a sputtering system using a plate-like inductively-coupled antenna for generating plasma by a radio-frequency induction electromagnetic field.

### BACKGROUND ART

With the enlargement of solar cells, displays, and other devices, there has been a demand for an inexpensive plasma processing system capable of quickly and uniformly processing a large area on the surface of a substrate by using plasma. Current plasma processing systems that have been developed and put to use in performing a sputtering process make use of DC discharge plasma, parallel-plate radio-frequency plasma, electron-cyclotron-resonance (ECR) plasma, helicon plasma, and other types of plasma.

A typical and conventional sputtering system is a magnetron sputtering system, which uses a magnetic field in order to increase the sputtering rate. If the substrate is large, a strong magnetic field is required to increase the sputtering rate. However, a low-intensity magnetic field is required for the sake of uniform film thickness. There is, therefore, a need to satisfy these conflicting conditions. In addition, for the conventional magnetron sputtering system, it is difficult to regulate the amount of sputtered particles emanating from all over the target in a tunnel-like magnetic field formed by the magnetron.

Patent Document 1 discloses an invention relating to a large-area magnetron sputtering system. The magnetron sputtering system includes: a vacuum chamber in which a substrate is placed on which a film is to be formed; a target plate arranged parallel to the substrate; a back plate to which the target plate is attached; magnetic units, which are supported on the back plate so as to be movable parallel to the substrate and the target plate, and which are separated from each other in the direction perpendicular to their moving direction; and a moving mechanism for moving each of the magnetic units.

These magnetron sputtering systems require a target plate slightly larger than a substrate, and can be highly expensive depending on the material of the target. Additionally, in order to increase the sputtering rate, it requires a magnetic field generator which has an area equal to or greater than the target plate, or another unit, such as a moving unit, for moving the magnetic field generator to increase the uniformity of sputtering. Further, since increasing the area of the back plate increases the stress due to atmospheric pressure, it is necessary to increase the thickness of the back plate to decrease the level of deformation, which significantly increases the weight of the plate. Such a system is difficult to handle.

Patent Document 2 discloses a technology relating to a facing-targets type sputtering system having a box-shaped sputtering unit. In the sputtering system, target plates are attached onto two opposing sides of the box-type sputter unit, and a direct-current voltage is applied between the bottom portion and the two sides to which the targets have been attached in the box-type sputter unit, where the two sides are negative with respect to the bottom portion. This generates discharge plasma, thereby sputtering the targets, and forming a film on the surface of the substrate placed in the bottom portion of the box-type sputter unit. As with the system of Reference 1, this sputtering system uses a magnetic field generator for generating a magnetic flux perpendicular to the target plates.

Increasing the distance between the facing targets for a large substrate lowers the intensity of a plasma-confining magnetic field in a facing direction, preventing the facing-targets sputtering assembly from functioning sufficiently. Therefore, the distance between the magnets is limited to a maximum of about 20 cm. Hence, in the case of forming a film on a stationary substrate, the substrate size is limited to about 20 cm or less. In the case where the sputtering system employs an in-line system in which the substrate is moving while the film is being formed, the sputtering system treats a substrate with a large area by moving it in the facing direction of the target plates and by increasing the length of the targets in the direction perpendicular to the facing direction. In this case, the targets to be employed assume a greatly elongated shape, which causes problems in that it is difficult both to uniformly cool and to handle the targets. In addition, the atoms of the sputtered target are reattached or deposited onto the inner wall of the box-shaped unit and the target plate. Consequently, only between a third and a fourth of the sputtered atoms are effectively used for the film formation.

### BACKGROUND ART DOCUMENT

### PATENT DOCUMENTS

[Patent Document 1] JP-A 9-031646
[Patent Document 2] WO-A 2006/070623
[Patent Document 3] WO-A 2009/142016

### DISCLOSURE OF THE INVENTION

### PROBLEMS TO BE SOLVED BY THE INVENTION

The problem to be solved by the present invention is to provide a sputtering system capable of efficiently generating high-density plasma near a sputter target and having a high sputtering rate. The present invention also aims at providing a large-area sputtering system and plasma processing system having a simple structure, with easy attachment/detachment and maintenance of the sputter target.

### MEANS FOR SOLVING THE PROBLEMS

The inventors of the present invention have developed an inductively-coupled plasma (ICP) generating system and a plasma processing system (refer to Patent Document 3) in which a flange having an opening and forming a part of a vacuum chamber is provided, and a plate-like radio-frequency antenna conductor is provided so as to cover the opening. A radio-frequency current is passed through the radio-frequency antenna conductor to generate discharge plasma. The present invention has been developed in the process of developing the previously described inductively-coupled plasma processing system capable of generating high-density plasma.

To solve the previously described problem, the present invention provides the following sputtering systems.
(1) A sputtering system, including:
   a) a vacuum chamber;
   b) a radio-frequency antenna conductor plate (which will hereinafter be called as an ICP antenna conductor), which is a conductor plate placed so as to close an opening provided on a top plate of the vacuum chamber and to which a sputter target plate can be attached on a surface thereof facing the inside of the vacuum chamber;
   c) a substrate holding table provided in the vacuum chamber;
   d) an exhaust unit for evacuating a gas in the vacuum chamber; and
   e) a gas introducer for introducing a process gas into the vacuum chamber.
(2) The sputtering system according to system (1), wherein the ICP antenna conductor is integrated with the sputter target plate. The ICP antenna conductor and the sputter target plate can be integrated by using screws, an adhesive, or other means. When screws are used, they may preferably be made of the same material as that of the sputter target plate. When an adhesive is used, it may preferably have a thermal resistance of 150°C or more.
(3) The sputtering system according to either system (1) or (2), wherein the surface of the ICP antenna conductor, apart from the portion onto which a sputter target plate can be attached, is covered with a high-permeability film made of a material whose magnetic permeability is higher than that of the ICP antenna conductor.
(4) The sputtering system according to any one of systems (1) through (3), wherein a cooling unit is provided on the atmosphere side of the ICP antenna conductor.
(5) The sputtering system according to any one of systems (1) through (4), wherein the longitudinal length of the ICP antenna conductor is a quarter or less of the wavelength corresponding to the frequency of the radio-frequency power to be fed to the ICP antenna conductor.
(6) The sputtering system according to any one of systems (1) through (5), wherein:
   a plurality of aforementioned openings are provided in the top plate at predetermined intervals;
   a plurality of aforementioned ICP antenna conductors are placed so as to close the plurality of openings; and
   a radio-frequency power is fed to each of the ICP antenna conductors.
(7) The sputtering system according to any one of systems (1) through (6), wherein, to the ICP antenna conductor, a radio-frequency power is fed via a matching unit and a bias voltage is applied via a coil.
(8) The sputtering system according to system (7), wherein the bias voltage is a negative pulsating flow voltage, a negative triangular wave voltage, or a negative rectangular wave voltage (including a pulse voltage), produced by half-wave rectification or full-wave rectification of an alternating voltage having a frequency of 300 kHz or less.
(9) The sputtering system according to either system (7) or (8), wherein the bias voltage is controllable.
(10) The sputtering system according to any one of systems (1) through (9), wherein the feed end of each ICP antenna conductor plate is connected to a radio-frequency power source via a matching unit, and the ground end of each ICP antenna conductor plate is grounded via a capacitor.
(11) The sputtering system according to any one of systems (1) through (10), wherein the radio-frequency power fed to each ICP antenna conductor is controllable.

### EFFECTS OF THE INVENTION

The present invention provides a sputtering system capable of efficiently generating high-density plasma above the surface of a sputter target plate, and hence having a high sputtering rate. In addition, the sputtering system of the present invention has a simple structure and the sputter target can be easily attached, detached, and maintained. Further, the provision of a plurality of ICP antenna conductors can result in a large-area sputtering system and a plasma processing system capable of controlling the uniformity of the sputtering.

### BRIEF DESCRIPTION OF THE DRAWINGS

Fig. 1 is a schematic vertical sectional view showing the first embodiment of the sputtering system according to the present invention.
Fig. 2 is a schematic vertical sectional view showing an example of the ICP antenna conductor used in the sputtering system according to the present invention.
Fig. 3 is a graph showing the power efficiency characteristic of the sputtering system of the first embodiment.
Fig. 4 is a graph showing the relationship between the radio-frequency power and the plasma density generated in the sputtering system of the first embodiment.
Fig. 5 is a graph showing the relationship between the bias voltage and the thickness of the sputter film in the first embodiment.
Fig. 6 is a schematic vertical sectional view showing the second embodiment in which multiple ICP antenna conductors are placed.
Fig. 7 is a conceptual diagram showing the method of feeding and controlling multiple ICP antenna conductors.

### BEST MODES FOR CARRYING OUT THE INVENTION

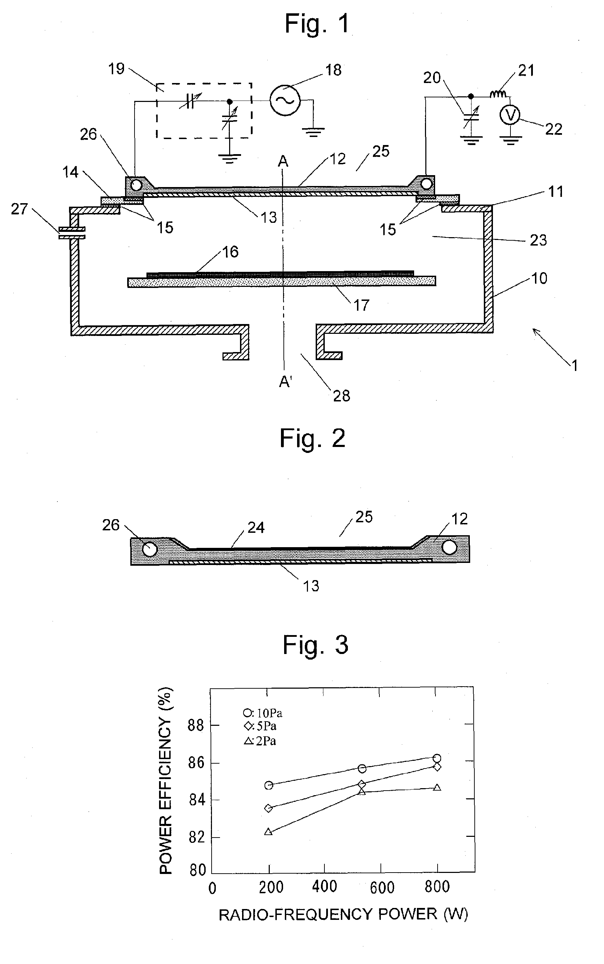

An embodiment of the sputtering system according to the present invention will now be described. Fig. 1 shows a schematic vertical sectional view of the main components. The sputtering system 1 of the present embodiment includes: a vacuum chamber 10 in which discharge plasma is formed; a top plate 11 for closing the upper portion of the vacuum chamber; an ICP antenna conductor 12 provided so as to close an opening provided in the top plate; a substrate holding table 17 provided in the inner space 23 of the vacuum chamber; an outlet (exhaust unit) 28 for ejecting the gas from inside the vacuum chamber with a vacuum pump (not shown); and a gas introduction port (gas introducer) 27 for introducing a process gas into the inner space 23 of the vacuum chamber. The ICP antenna conductor 12 may preferably be made of copper or aluminum, both of which are non-magnetic materials and good conductors of electricity and heat. The shape of the ICP antenna conductor is typically rectangular, but may be another type, such as circular or oval. A sputter target plate 13 is attached (joined) to the surface of the ICP antenna conductor 12 facing the inside of the vacuum chamber. One end of the ICP antenna conductor 12 is connected to a radio-frequency power source 18 through a matching unit 19, and the opposite end is grounded through a capacitor 20.

The sputtering system 1 of the present embodiment makes use of the synergic effect of the inductively-coupled discharge plasma (ICP) and the capacitively-coupled discharge plasma (CCP), which are both generated by just feeding a radio-frequency current to the ICP antenna conductor 12. This can generate high-density plasma of 5×10¹¹ cm⁻³ near the surface of the sputter target plate 13 which is attached to the ICP antenna conductor 12.

One end of the ICP antenna conductor 12 is connected to the radio-frequency power source 18 through the matching unit 19, while the other end thereof is grounded through the capacitor 20, resulting in the ICP antenna conductor 12 being electrically floated. Therefore, controlling the bias voltage applied to the ICP antenna conductor 12 can control the amount and energy of ion current impinging on the sputter target plate 13. This allows an almost uniform amount of particles to be sputtered from all over the sputter target plate 13.

The sputtering system 1 may have a bias power source 22 for applying a negative bias voltage, such as, for example, a negative pulsating voltage which can be produced by half-wave or full-wave rectification of an alternating voltage, a negative triangular wave voltage, or a negative rectangular wave voltage to the ICP antenna conductor 12 through a coil 21. The cycle frequency of these negative bias voltages may be 300 kHz or less, and is preferably between 10 kHz and 100 kHz. The amount and energy of the ions injected to the sputter target plate 13 can be controlled by controlling the negative bias voltage, which also allows the sputtering rate to be controlled. More importantly, the application of a pulsating flow voltage or a pulse voltage with a cycle frequency of 10 kHz or more enables a sputtering of not only a conductive target material but also a dielectric target material.

The sputter target plate 13 can be attached or joined to the ICP antenna conductor 12 with, for example, screws or an adhesive. This makes it possible for any material to be sputtered simply by changing the sputter target plate 13 while using the same ICP antenna conductor, greatly facilitating the attachment/detachment and maintenance of the target. Screws, if used, should be preferably made of the same material as that of the sputter target plate 13. If an adhesive is used, it should preferably resist a heat of 150°C or more.

Apart from the surface to which the sputter target plate 13 is joined (target plate joining surface), the surface of the ICP antenna conductor 12 may be covered with a high-permeability film 24, as shown in Fig. 2, so that the covered surface other than the target plate joining surface will have a higher impedance to radio-frequency waves. This enables a radio-frequency current to be concentrated on the target plate joining surface, allowing discharge plasma to be generated in the vicinity of the sputter target plate 13 at a density higher than before. Consequently, the sputtering rate can be increased. The high-permeability film 24 may be made of iron, cobalt, nickel, or an alloy thereof.

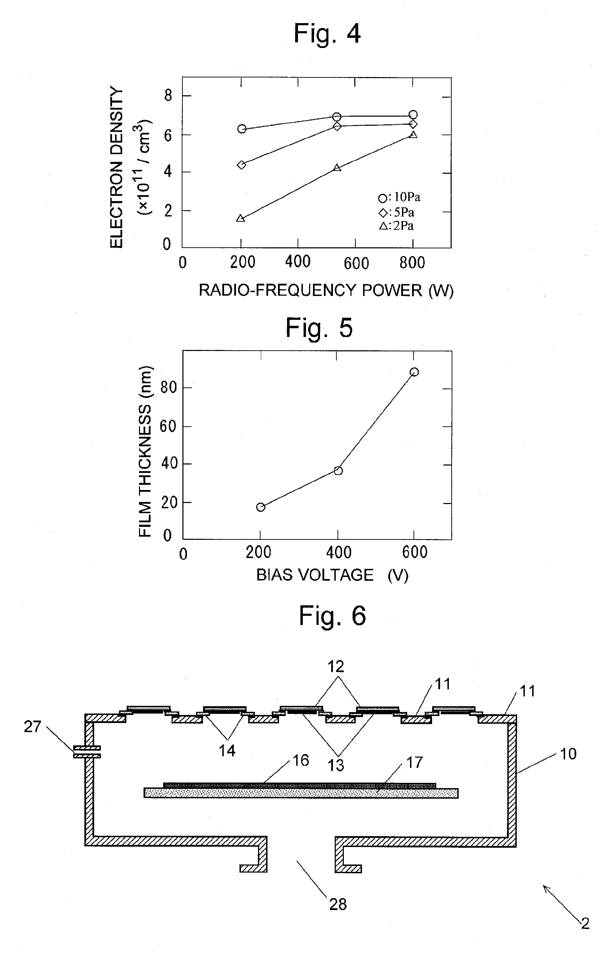

Fig. 6 shows another embodiment of the sputtering system according to the present invention. In the sputtering system 2 of the present embodiment, a plurality of openings are provided at constant intervals in a part of the vacuum chamber 10 (e.g. the top plate 11), and the ICP antenna conductor 12 to which a sputter target plate 13 has been joined is attached to each of the openings. The other configurations are the same as those of the aforementioned sputtering system 1. The vertical section shown in Fig. 6 corresponds to the vertical section at line A-A' in Fig. 1, which has a single long dash alternating with two short dashes. If vertically sectioned in the same direction as in Fig. 1, the sputtering system 2 of the present embodiment will have the same configuration as the aforementioned sputtering system 1. The sputtering system 2 of the present embodiment can form a sputter film on the surface of a large-area substrate 16 placed on the substrate holding table 17 by feeding a radio-frequency power to each of the ICP antenna conductors 12. In addition, sputtering can be performed uniformly by controlling the bias voltage or the radio-frequency power fed to each of the ICP antenna conductors 12, enabling a uniform formation of a film across a large area.

In the case where a plurality of ICP antennas are provided, a sputter target plate made of a different material may be joined to one or more specific ICP antennas. This allows a formation of any type of film including a plurality of elements, such as a mixed thin film, a compound thin film, or a heterogeneous junction thin film.

In the plate-like ICP antenna conductor of the present application, a radio-frequency current tends to flow on both sides rather than in the central portion in the cross section of the ICP antenna conductor due to the skin effect. Therefore, if a plurality of ICP antenna conductors are provided, it is preferable that the width (W) of the ICP antenna conductor is approximately equal to the intervals (L) between the adjacent ICP antenna conductors. In order to form a uniform sputtering film on the surface of the substrate, the ratio (H/L) of the distance (H) between the sputter target plate and the substrate and the intervals (L) between the adjacent ICP antenna conductors should preferably be 1 through 3.

### FIRST EMBODIMENT

The configuration of the first embodiment according to the present invention will now be described with reference to Fig. 1. The ICP antenna conductor 12 used in the present embodiment is an aluminum plate having a width of 5 cm and a length of 50 cm. The surface of the ICP antenna conductor 12 facing the inner space (plasma formation space) 23 of the vacuum chamber has a planer shape, and a nickel sputter target plate 13 is joined to the surface with nickel screws. A concave 25 is provided on the atmosphere side of the ICP antenna conductor 12, and a cooling channel 26 is provided in the thick fringe area of the ICP antenna conductor.

The aforementioned ICP antenna conductor 12 was attached to the opening of the top plate 11 of the vacuum chamber, with vacuum sealing members 15 and an insulating frame 14 inserted therebetween. A polyether ether ketone (PEEK) material was used for the insulating frame 14. One end of the ICP antenna conductor 12 was formed with a copper plate and was connected to the radio-frequency power source 18 via a matching unit. The other end was connected to the case of the matching unit 19 at the ground potential via the variable capacitor 20. The ICP antenna conductor 12 was further connected to the bias power source 22 via the coil 21, and the bias voltage was controlled to regulate the sputtering rate.

The following experiment was performed with the sputtering system of the first embodiment. First, the vacuum chamber was evacuated to 1×10⁻³ Pa or less. Then an argon gas was introduced into the vacuum chamber 10, and the gas pressure was regulated to be 2 through 10 Pa. A radio-frequency power with a frequency of 13.56 MHz and a power output of 200 through 800 W was fed to the ICP antenna conductor 12 to generate plasma in the vacuum chamber 10.

The ICP antenna conductor 12 used in the present embodiment is a plate-shaped antenna, so that it has an extremely low impedance, and a large amount of radio-frequency current can be passed through it. As shown in Fig. 3, it has the power efficiency of approximately 85%, and is capable of forming high-density plasma in the vicinity of the surface of the ICP antenna conductor 12.

The electron density of the plasma generated in the plasma formation space 23 was measured by using a Langmuir probe (not shown) provided in the vacuum chamber. The result is shown in Fig. 4. The measurement result shows the electron density in the plasma formation space 23 as measured at a distance of 5.4 cm from the surface of the ICP antenna conductor 12. With a radio-frequency power of 800 W, a high electron density of approximately 6×10¹¹/cm³ was obtained. This is approximately one order of magnitude higher than the electron density achieved by a conventional capacitively-coupled plasma (CCP) method.

As a bias voltage, a negative pulsating flow voltage in which an alternating-current voltage of 50 kHz was half-wave rectified was applied. Fig. 5 shows the relationship between the wave height of the bias voltage and the thickness of the nickel film formed on the glass substrate 16 located 7 cm below the nickel sputter target plate 13. As is clear from Fig. 5, increasing the bias voltage significantly increases the film formation rate, and controlling the bias voltage can regulate the film formation rate as desired. This embodiment shows that, with a bias voltage of 400 V or more, a glow discharge from the bias voltage is superimposed to increase the plasma density, significantly increasing the sputtering rate.

In this invention, the radio-frequency voltages at both ends of the ICP antenna conductor 12 can almost be equalized by adjusting the capacity of the capacitor 20, thus enabling the formation of the plasma which is virtually uniform in the longitudinal direction of the ICP antenna conductor 12. Although the sputter target plate was made of nickel in the present embodiment, the material is not limited thereto. Using a frequency of 10 kHz or more for the pulsating flow bias power source enables a sputtering of a dielectric target material.

### SECOND EMBODIMENT

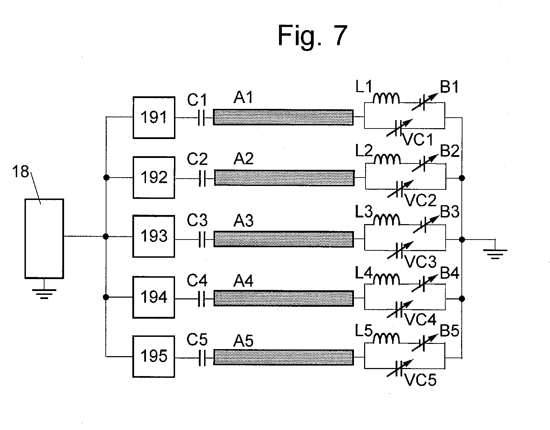

The configuration of the second embodiment of the sputtering system of the present invention will now be described with reference to Figs. 6 and 7. In the present embodiment, five ICP antenna conductors, each having the same dimensions as those of the ICP antenna conductor used in the first embodiment, were arranged almost in parallel and at intervals of 12 cm in the aforementioned sputtering system 2, as illustrated in Fig. 6. The distance between the ICP antenna conductors 12 and the substrate 16 was set at 15 cm.

Fig. 7 is a conceptual diagram showing the method of feeding and controlling the five ICP antenna conductors. The feed ends of the ICP antenna conductors (A1 through A5) are connected to the radio-frequency power source 18 via the capacitors (C1 through C5) and the matching units 191 through 195, respectively. The ground ends of the ICP antenna conductors A1 through A5 are grounded via variable capacitors (VC1 through VC5 respectively). The ICP antenna conductors A1 through A5 are respectively connected to bias power sources (B1 through B5) via coils (L1 through L5). In the present embodiment, the antenna conductors A1 through A5 are fed with power via the matching units by a single radio-frequency power source. However, the present invention is not limited thereto, and multiple radio-frequency power sources may be used.

This configuration enables the adjustment and control of the impedances and the bias voltages of the ICP antenna conductors A1 through A5. In the present embodiment, a radio-frequency power having the frequency of 13.56 MHz and the power output of 500 through 1500 W, and a negative pulsating flow voltage having a wave height of 300 V through 600 V and a frequency of 50 kHz were applied to the ICP antenna conductors. By adjusting the bias voltages for the ICP antenna conductors, a nickel film with a thickness accuracy of ±5% or less was formed on the surface of a square substrate having a one-side length of 50 cm.

The present embodiment has revealed that even if the impedances of the ICP antenna conductors A1 through A5 are adjusted in advance, the film formation rate will not always be uniform, and correction will be required by adjusting the bias voltages. It is possible to make the film formation rate uniform across a large area by individually controlling the bias voltages applied to the ICP antenna conductors A1 through A5.

### EXPLANATION OF NUMERALS

10 ... Vacuum Chamber
11 ... Top Plate
12, A1 through A5 ... ICP Antenna Conductor
13 ... Sputter Target Plate
14 ... Insulating Frame
15 ... Vacuum Seal Member
16 ... Substrate
17 ... Substrate Holding Table
18 ... Radio-Frequency Power Source
19 ... Matching Unit
20 ... Capacitor
21 ... Coil
22 ... Bias Power Source
23 ... Inner Space of the Vacuum Chamber (Plasma Formation Space)
24 ... Highly Magnet-Permeable Film
26 ... Cooling Channel
27 ... Gas Introduction Port
28 ... Outlet

## Claims

1. A sputtering system, comprising:
a) a vacuum chamber;
b) a radio-frequency antenna conductor plate, which is a conductor plate placed so as to close an opening provided on a top plate of the vacuum chamber and to which a sputter target plate can be attached on a surface thereof facing an inside of the vacuum chamber;
c) a substrate holding table provided in the vacuum chamber;
d) an exhaust unit for evacuating a gas in the vacuum chamber; and
e) a gas introducer for introducing a process gas into the vacuum chamber.

2. The sputtering system according to claim 1, wherein the radio-frequency antenna conductor plate is integrated with the sputter target plate.

3. The sputtering system according to either claim 1 or 2, wherein a surface of the radio-frequency antenna conductor plate, apart from a portion onto which a sputter target plate can be attached, is covered with a high-permeability film.

4. The sputtering system according to any one of claims 1 through 3, wherein a cooling unit is provided on an atmosphere side of the radio-frequency antenna conductor plate.

5. The sputtering system according to any one of claims 1 through 4, wherein a longitudinal length of the radio-frequency antenna conductor plate is a quarter or less of a wavelength corresponding to a frequency of a radio-frequency power to be fed.

6. The sputtering system according to any one of claims 1 through 5, wherein:
a plurality of aforementioned openings are provided in the top plate at predetermined intervals;
a plurality of aforementioned radio-frequency antenna conductors are placed so as to close the plurality of openings; and
a radio-frequency power and a bias voltage are fed to each of the radio-frequency antenna conductors.

7. The sputtering system according to any one of claims 1 through 6, wherein, to the radio-frequency antenna conductor plate, a radio-frequency power is fed via a matching unit and a bias voltage is applied via a coil.

8. The sputtering system according to claim 7, wherein the bias voltage is a negative pulsating flow voltage produced by half-wave rectification or full-wave rectification of an alternating voltage having a frequency of 300 kHz or less, a negative triangular wave voltage, or a negative rectangular wave voltage (including a pulse voltage).

9. The sputtering system according to either claim 7 or 8, wherein the bias voltage is controllable.

10. The sputtering system according to any one of claims 1 through 9, wherein a feed end of each radio-frequency antenna conductor plate is connected to a radio-frequency power source via a matching unit, and a ground end of each radio-frequency antenna conductor plate is grounded via a capacitor.

11. The sputtering system according to any one of claims 1 through 10, wherein the radio-frequency power fed to each radio-frequency antenna conductor plate is controllable.
